# FASCICULE DE BREVET EUROPEEN

(11) **EP 3 631 375 B1**
(45) Date de publication et mention de la délivrance du brevet: **24.03.2021**
(21) Numéro de dépôt: 18735653.0
(22) Date de dépôt: 25.05.2018
(51) Int. Cl.: G01D 11/30, G01D 5/12

(54) **MOTEUR COMPORTANT UN DISPOSITIF DE MESURE POUR MOTEUR A COMBUSTION INTERNE COMPRENANT UN DETECTEUR DE PASSAGE D'UNE CIBLE**
MOTOR, DER EINE MESSVORRICHTUNG FÜR EINE MIT EINEM OBJEKT-DUCHGANGS-DETEKTOR AUSGESTATTETE BRENNKRAFTMASCHINE ENTHÄLT
MOTOR COMPRISING A MEASURING DEVICE FOR AN INTERNAL COMBUSTION ENGINE COMPRISING A TARGET PASSING DETECTOR

(30) Priorité: 29.05.2017 FR 1754683
(43) Date de publication de la demande: 08.04.2020
(73) Titulaire: MCE 5 Development, 69100 Villeurbanne (FR)
(72) Inventeur: BERTHEAU, René-Pierre, 69700 Montagny (FR)
(74) Mandataire: IP Trust
(86) Numéro de dépôt international: PCT/FR2018/051235
(87) Numéro de publication internationale: WO 2018/220319

(56) Documents cités:
- EP-A1- 3 087 924
- WO-A1-2010/038102
- DE-A1- 4 426 501
- DE-A1-102015 217 152

## Description

### DOMAINE DE L'INVENTION

La présente invention concerne un dispositif de mesure comprenant un détecteur de passage d'une cible porté par un piston d'un moteur à combustion interne. Ce type de dispositif peut trouver une application dans le domaine des moteurs à rapport volumétrique variable.

### ARRIERE PLAN TECHNOLOGIQUE DE L'INVENTION

En avant-propos, on rappelle qu'un moteur à combustion interne comprend généralement un piston de combustion présentant une jupe permettant de guider le piston dans le cylindre, une bielle associée du côté de son pied à l'axe de piston et du côté de sa tête au palier d'un vilebrequin. Ces deux paliers sont généralement d'axes parallèles. La bielle a pour fonction de transmettre le mouvement de translation du piston d'un « point mort haut » à un « point mort bas » au mouvement de rotation du vilebrequin.

Il est généralement admis que l'adaptation du rapport volumétrique d'un moteur à sa charge permet d'améliorer grandement le rendement énergétique du moteur. Par exemple il est parfois recherché de faire varier le rapport volumétrique entre environ une valeur de 12 en l'absence de charge à une valeur de l'ordre de 8 à pleine charge.

On rappelle que le rapport volumétrique d'un moteur à combustion interne, souvent appelé taux de compression, correspond au rapport entre le volume de la chambre de combustion lorsque le piston est à son point mort bas ; et le volume de la chambre de combustion lorsque le piston est à son point mort haut.

On connaît de multiples solutions dans l'état de la technique permettant d'ajuster le rapport volumétrique et/ou la cylindrée d'un moteur à combustion interne.

Quelle que soit la solution mise en œuvre pour permettre cet ajustement, il est souvent nécessaire d'avoir une mesure la plus directe possible du rapport volumétrique, par exemple au niveau d'un calculateur, pour piloter efficacement le moteur. Cette information peut permettre, par exemple, de déterminer l'instant précis, ou le décalage angulaire précis, auquel la bougie de la chambre de combustion du moteur doit être allumée.

On connaît ainsi des solutions mettant en œuvre un capteur de position sans contact, le capteur étant disposé fixement sur le carter cylindre et repérant la proximité d'une cible disposée fixement sur le piston ou sur la bielle. Il peut s'agir d'un capteur à effet Hall, et dans ce cas la cible comprend un élément magnétique ou une masse métallique. Les documents DE4426501 et WO2010038102 décrivent de tels détecteur de passage d'une cible. Le signal délivré par le capteur peut être analysé, et son maximum indique l'instant auquel la cible est positionnée au plus près du capteur. Un modèle numérique ou des tables préétablies permettent de déterminer le rapport volumétrique en combinant par exemple l'information délivrée par le capteur à la position angulaire du vilebrequin Le document DE102015217152 décrit un moteur à combustion interne avec un capteur inductif intégré pour mesurer la position d'un piston.

L'espace défini par le carter cylindre dans lequel différentes pièces mobiles (vilebrequin, pistons, bielles...) sont en mouvement est particulièrement restreint. Les éléments additionnels qui sont placés dans ce volume (cible, capteur...) doivent être précisément disposés et configurés pour ne pas interférer avec le fonctionnement du moteur, tout en assurant leurs fonctions avec une grande fiabilité. On cherche notamment à éviter l'intégration d'éléments additionnels qui viendrait modifier la géométrie des cylindres et/ou de tout usinage qui pourrait venir endommager une chemise dont peuvent être munis ces cylindres.

### BREVE DESCRIPTION DE L'INVENTION

En vue de la réalisation de l'un de ces buts, l'objet de l'invention propose un moteur à combustion interne comprenant :
- Une bielle présentant un pied et un piston associé au pied de bielle, le piston comprenant deux portions de jupe, deux parois latérales de renfort reliant les deux portions de jupe entre elles ;
- une cible disposée sur une des parois latérales ou sur le pied de bielle ;
- un carter-cylindre définissant au moins un cylindre et présentant au moins un alésage débouchant sous le cylindre ;
- un dispositif de mesure disposé dans l'alésage du carter-cylindre et comprenant un détecteur de passage de la cible, un connecteur et au moins un câble reliant le détecteur de passage au connecteur, une première partie supportant le connecteur, une seconde partie supportant le détecteur de passage, la première partie et la seconde partie étant articulées entre elles.

La cible est disposée en vis-à-vis du détecteur de passage, lorsque le piston est à proximité d'une position de point mort bas.

Selon d'autres caractéristiques avantageuses et non limitatives de l'invention, prises seules ou selon toute combinaison techniquement réalisable :
- la première partie du dispositif de mesure est entièrement insérée dans le carter-cylindre ;
- l'alésage est perpendiculaire à un axe de vilebrequin du moteur ;
- le détecteur de passage est un capteur à effet Hall ;
- le moteur présentant un rapport volumétrique variable ;
- les parois du piston sont munies de bossages renforcés pour retenir un axe de piston, et dans lequel la cible peut être disposée sur l'un des bossages renforcés ;
- la cible est disposée au voisinage du pied de la bielle ;
- la cible est un corps magnétique ou métallique.

### BREVE DESCRIPTION DES DESSINS

D'autres caractéristiques et avantages de l'invention ressortiront de la description détaillée de l'invention qui va suivre en référence aux figures annexées sur lesquelles :
- les figures 1a et 1b représentent un piston d'un moteur à combustion interne selon deux modes de mise en œuvre conformes à l'invention;
- la figure 2 représente un moteur à combustion interne comprenant un piston conforme à l'invention ;
- les figures 3a et 3b représentent respectivement le dispositif de mesure au cours de son insertion dans le bloc moteur, et dans sa position de fonctionnement ;
- la figure 4 représente un dispositif de mesure muni d'un élément de blocage en position de fonctionnement et d'une tirette de commande.
- La figure 5 représente un dispositif de mesure comprenant un élément de rappel.

### DESCRIPTION DETAILLEE DE L'INVENTION

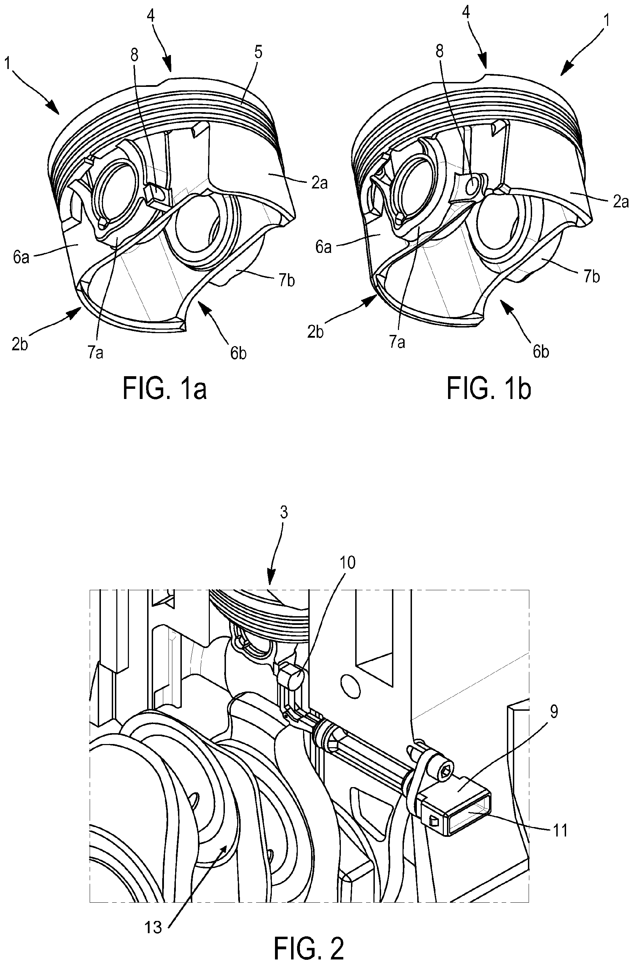

Les figures 1a et 1b représentent un piston 1 combustion d'un moteur à combustion interne selon deux modes de mise en œuvre conformes à l'invention. Le piston 1 est muni d'une jupe 2a, 2b permettant de guider le piston 1 dans un cylindre 3 défini par un carter-cylindre du moteur. De manière tout à fait conventionnelle, la jupe 2 est reliée à la calotte 4 du piston 1 et porte des gorges 5 pour recevoir des segments. La jupe 2 est composée de deux portions 2a, 2b dont la section transversale est en forme de portion de cercle. Les deux portions de jupe 2a, 2b sont reliées l'une à l'autre par l'intermédiaire de deux parois latérales 6a, 6b. Ces deux parois latérales 6a, 6b sont munies de bossages renforcés 7a, 7b pour recevoir un axe du piston, et associer ce piston à un pied de bielle.

On prévoit de disposer une cible 8 sur une des deux parois latérales 6 a, 6b afin d'éviter que la cible 8 n'interfère avec le mouvement du piston 1. La cible 8 peut être constituée d'un corps métallique et/ou magnétique, ou d'une manière générale de tous matériaux dont le passage devant un détecteur disposé dans le moteur peut être repéré.

De préférence, la cible 8 est disposée sur la partie basse d'une des parois latérales 6a, 6b du piston 1, c'est-à-dire à l'opposé à la calotte 4. Elle peut être placée indifféremment du côté admission ou échappement du piston 1. À titre d'exemple, et comme cela est présenté sur la figure 1a, la cible 8 peut être portée par un des bossages renforcés 7a, 7b, ou, comme cela est représenté sur la figure 1b, la cible 8 peut être portée sur une nervure de renforts d'une des parois latérales 6a, 6b.

Dans une alternative non représentée, la cible peut être disposée sur la bielle, de préférence au voisinage du pied de bielle.

On a représenté sur la figure 2, un moteur à combustion interne comprenant un piston 1 conforme à ce qui vient d'être décrit. Le piston est placé dans un cylindre 3 défini par le carter-cylindre. Le carter-cylindre présente un alésage débouchant sous le cylindre 3. Cet alésage est dimensionné pour recevoir un dispositif de mesure 9 comprenant, à une extrémité destinée à être placée à l'intérieur du bloc-moteur, un détecteur de passage 10. Le détecteur de passage peut être par exemple un capteur à effet Hall, configuré pour repérer le passage de la cible 8. Lorsqu'il est en position de fonctionnement conforme dans l'alésage, le dispositif de mesure 9 est disposé en vis-à-vis de la cible 8, lorsque le piston est en position de point mort bas, ou à proximité de de cette position.

Dans la configuration représentée sur la figure 2, on évite de faire déboucher l'alésage directement dans le cylindre 3, ce qui aurait été nécessaire si le dispositif de mesure 9 n'était pas articulé. Un tel usinage est en effet susceptible d'endommager la surface interne du cylindre 3 et d'affecter les performances du moteur, notamment lorsque le cylindre 3 comprend une chemise intégrée ou insérée à la coulée.

De plus, cette configuration permet d'obtenir une mesure très directe, et donc précise, de la position du piston 1 sans interférer avec le fonctionnement du moteur, ce qui aurait été plus difficile à obtenir en faisant porter la cible 8 par une bielle.

Avantageusement, pour en faciliter l'usinage, l'alésage formé dans le carter cylindre est perpendiculaire à l'axe principal de vilebrequin 13.

Le dispositif de mesure 9, comme on l'a vu, comporte un détecteur de passage 10 de la cible 8. Il comporte également au moins un câble de liaison, reliant le détecteur 10 à un connecteur 11. Le câble et le connecteur permettent de communiquer la mesure de détection de passage à un calculateur.

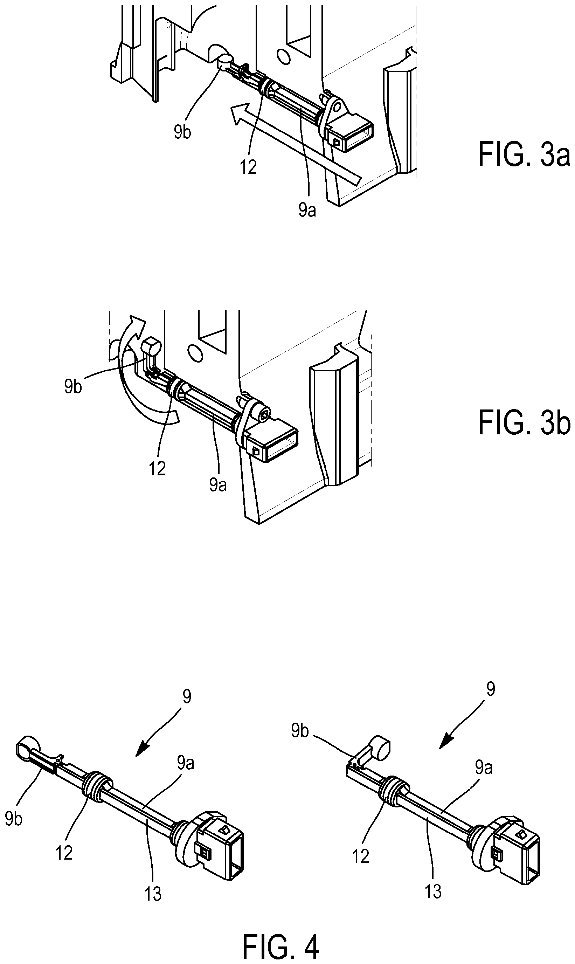

Pour permettre de mettre en vis-à-vis la cible 8, lorsque le piston est en position de point mort bas, et le détecteur de passage 10, le dispositif de mesure 9 est composé en deux parties 9a, 9b articulées entre elles. Les figures 3a et 3b représentent respectivement le dispositif de mesure 9 au cours de son insertion dans le bloc moteur, et dans sa position de fonctionnement.

La première partie 9a supporte à son extrémité libre le connecteur 11. Elle présente une longueur suffisante pour que, lorsque le dispositif de mesure 9 est placé dans l'alésage du carter-cylindre, la deuxième partie 9b soit entièrement placée à l'intérieur de l'espace défini par le bloc-moteur. La deuxième partie 9b supporte à son extrémité libre le détecteur de passage 10. Les deux parties 9a, 9b peuvent être creuses de manière à pouvoir faire circuler le câble entre le détecteur 10 et le connecteur 9.

Le dispositif de mesure 9 est sélectivement configurable dans une position d'insertion dans laquelle la première partie 9a et la deuxième partie 9b sont alignées l'une avec l'autre. Cette configuration, représentée sur la figure 3a, permet d'insérer le dispositif de mesure 9 dans l'alésage du carter-cylindre, et de le placer dans sa position de fonctionnement.

Le dispositif de mesure 9 est également sélectivement configurable dans une position de fonctionnement, dans laquelle la première partie 9a et la deuxième partie 9b ne sont pas alignées l'une avec l'autre. Ainsi, dans la configuration de fonctionnement, la première partie 9a et la deuxième partie 9b peuvent par exemple présenter entre elles un angle de 90°, comme cela est apparent sur les figures 2 et 3b. Quel que soit cet angle, l'articulation existant entre la première partie 9a et la deuxième partie 9b permet de placer le dispositif de mesure 9 en position de fonctionnement dans lequel le détecteur 10 est placé en vis-à-vis de la cible 8, lorsque le piston 1 est à son point mort bas ou proche de son point mort bas (ou à proximité de cette position).

Le dispositif de mesure peut porter une pièce d'étanchéité 12, coopérant avec l'alésage du carter-cylindre pour prévenir tout écoulement d'huile moteur en dehors du bloc-moteur.

Avantageusement, le dispositif de mesure 9 peut comprendre un élément de blocage, permettant de maintenir fermement le dispositif de mesure 9 en position de fonctionnement. Il peut s'agir d'un clip, ou d'une jambe de force. L'élément de blocage peut être mis en place manuellement lors du positionnement du dispositif de mesure 9 dans le carter-cylindre.

De manière préférée, et comme cela est représenté sur la figure 4, on peut prévoir de munir le dispositif de mesure d'un élément filaire, ou d'une tirette 13, longeant ou intégré au dispositif de mesure 9, permettant une commande de l'élément de blocage, depuis l'extérieur du moteur. On facilite ainsi, le montage et/ou le démontage du dispositif de mesure 9, puisqu'il n'est alors plus nécessaire d'avoir un accès direct à l'élément de blocage.

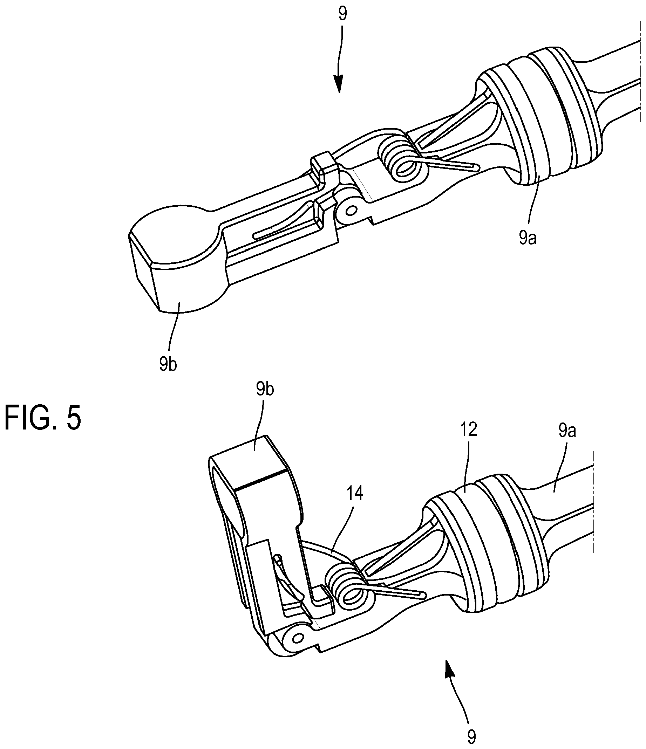

Dans un autre mode de mise en œuvre de l'invention, représenté sur la figure 5, l'élément de blocage du dispositif de mesure 9 peut comprendre ou consister en un élément de rappel 14 disposé au niveau de l'articulation, entre la première partie 9a et la deuxième partie 9b. Cet élément de rappel 14 tend à naturellement placer le dispositif de mesure 9 en position de fonctionnement en l'absence de tout effort extérieur. Il peut s'agir par exemple d'un ressort de torsion.

Dans ce mode de mise en œuvre, représenté sur la figure 5, le dispositif de mesure 9 est placé « en force » dans sa position d'insertion jusqu'à ce qu'une partie au moins de la première partie du dispositif de mesure 9 soit insérée dans l'alésage du carter-cylindre afin d'en permettre l'insertion. Lorsque, en poursuivant l'introduction du dispositif de mesure 9 dans le bloc-moteur, la deuxième partie 9b a entièrement pénétré dans le bloc-moteur, l'élément de rappel 14 configure le dispositif de mesure 9 dans sa position de fonctionnement.

Quel que soit le mode de mise en œuvre choisi, le dispositif de mesure 9 peut être extrait « en force » de l'alésage, par exemple pour des besoins de maintenance ou d'entretien, sans qu'il ne soit nécessaire d'accéder manuellement à l'élément de blocage, par l'intérieur du bloc moteur. Cet extraction conduit à placer naturellement la première partie 9a, et la deuxième partie 9b du dispositif de mesure en configuration d'insertion, en forçant l'articulation.

Bien entendu l'invention n'est pas limitée aux modes de mise en œuvre décrits et on peut y apporter des variantes de réalisation sans sortir du cadre de l'invention tel que défini par les revendications.

## Revendications

1. Moteur à combustion interne comprenant :
• Une bielle présentant un pied et un piston (1) associé au pied de bielle, le piston comprenant deux portions de jupe (2, 2b), deux parois latérales de renfort (6a, 6b) reliant les deux portions de jupe (2a, 2b) entre elles ;
• une cible (8) disposée sur une des parois latérales (6a, 6b) ou sur le pied de bielle ;
• un carter-cylindre définissant au moins un cylindre (3) et présentant au moins un alésage débouchant sous le cylindre ;
• un dispositif de mesure (9) disposé dans l'alésage du carter-cylindre et comprenant un détecteur de passage (10) de la cible (8), un connecteur (11) et au moins un câble reliant le détecteur de passage (10) au connecteur (11), une première partie (9a) supportant le connecteur (11), une seconde partie (9b) supportant le détecteur de passage (10), la première partie (9a) et la seconde partie (9b) étant articulées entre elles ;
la cible (8) étant disposée en vis-à-vis du détecteur de passage (10), lorsque le piston (1) est à proximité d'une position de point mort bas.

2. Moteur à combustion interne selon la revendication précédente dans lequel la première partie (9a) du dispositif de mesure (9) est entièrement insérée dans le carter-cylindre.

3. Moteur à combustion interne selon la revendication précédente dans lequel l'alésage est perpendiculaire à un axe de vilebrequin du moteur.

4. Moteur à combustion interne selon l'une revendications précédentes dans lequel le détecteur de passage (10) est un capteur à effet Hall.

5. Moteur à combustion interne selon l'une revendications précédentes, le moteur présentant un rapport volumétrique variable.

6. Moteur à combustion interne selon l'une des revendications précédentes dans lequel les parois (6a, 6b) sont munies de bossages renforcés (7a, 7b) pour retenir un axe de piston, et dans lequel la cible (8) est disposée sur l'un des bossages renforcés (7a, 7b).

7. Moteur à combustion interne selon l'une des revendications 1 à 5 dans lequel la cible (8) est disposée au voisinage du pied de la bielle.

8. Moteur à combustion interne selon l'une des revendications précédentes dans lequel la cible (8) est un corps magnétique ou métallique.

## Patentansprüche

1. Verbrennungsmotor, umfassend:
• eine Pleuelstange mit einem Fuß und einem dem Pleuelfuß zugeordneten Kolben (1), wobei der Kolben zwei Schaftabschnitte (2, 2b) und zwei verstärkende Seitenwandungen (6a, 6b) umfasst, die die beiden Schaftabschnitte (2a, 2b) miteinander verbinden;
• eine Scheibe (8), die an einer der Seitenwandungen (6a, 6b) oder am Pleuelfuß angeordnet ist;
• eine Zylindergehäuse, das mindestens einen Zylinder (3) definiert und mindestens eine Bohrung aufweist, die unter dem Zylinder angeordnet ist;
• eine Messvorrichtung (9), die in der Bohrung des Zylindergehäuses eingerichtet ist und einen Durchgangsdetektor (10) für die Scheibe (8), einen Anschluss (11) und mindestens ein den Durchgangsdetektor (10) mit dem Anschluss (11) verbindendes Kabel umfasst, wobei ein erster Teil (9a) den Anschluss (11) trägt, ein zweiter Teil (9b) den Durchgangsdetektor (10) trägt und der erste Teil (9a) und der zweite Teil (9b) gelenkig miteinander verbunden sind;
wobei die Scheibe (8), gegenüber dem Durchgangsdetektor (10) angeordnet ist, wenn sich der Kolben (1) nahe einer unteren Totpunktposition befindet.

2. Verbrennungsmotor nach dem vorhergehenden Anspruch, wobei der erste Teil (9a) der Messvorrichtung (9) vollständig in das Zylinderkurbelgehäuse eingesetzt ist.

3. Verbrennungsmotor nach dem vorhergehenden Anspruch, wobei die Bohrung senkrecht zu einer Kurbelwellenachse des Motors ist.

4. Verbrennungsmotor nach einem der vorhergehenden Ansprüche, wobei der Durchgangsdetektor (10) ein Hall-Effekt-Sensor ist.

5. Verbrennungsmotor nach einem der vorhergehenden Ansprüche, wobei der Motor ein variables Verdichtungsverhältnis aufweist.

6. Verbrennungsmotor nach einem der vorhergehenden Ansprüche, wobei die Wandungen (6a, 6b) mit verstärkten Vorsprüngen (7a, 7b) zur Aufnahme eines Kolbenbolzens versehen sind und die Scheibe (8) auf einem der verstärkten Vorsprünge (7a, 7b) eingerichtet ist.

7. Verbrennungsmotor nach einem der Ansprüche 1 bis 5, wobei die Scheibe (8) nahe des Pleuelfußes eingerichtet ist.

8. Verbrennungsmotor nach einem der vorhergehenden Ansprüche, wobei die Scheibe (8) ein magnetischer oder metallischer Körper ist.

## Claims

1. Internal combustion engine comprising:
• a connecting rod having a small end and a piston (1) associated with the connecting rod small end, the piston comprising two skirt portions (2, 2b), two reinforcing side walls (6a, 6b) interconnecting the two skirt portions (2a, 2b);
• a target (8) arranged on one of the side walls (6a, 6b) or on the connecting rod small end;
• a cylinder block defining at least one cylinder (3) and having at least one bore opening under the cylinder;
• a measuring device (9) arranged in the bore of the cylinder block and comprising a passage detector (10) for the target (8), a connector (11) and at least one cable connecting the passage detector (10) to the connector (11), a first part (9a) supporting the connector (11), a second part (9b) supporting the passage detector (10), the first part (9a) and the second part (9b) being hinged together;
the target (8) being arranged opposite the passage detector (10) when the piston (1) is close to a bottom dead center position.

2. Internal combustion engine according to the preceding claim, wherein the first part (9a) of the measuring device (9) is fully inserted into the cylinder block.

3. Internal combustion engine according to the preceding claim, wherein the bore is perpendicular to a crankshaft axis of the engine.

4. Internal combustion engine according to one of the preceding claims, wherein the passage detector (10) is a Hall effect sensor.

5. Internal combustion engine according to one of the preceding claims, the engine having a variable compression ratio.

6. Internal combustion engine according to one of the preceding claims, wherein the walls (6a, 6b) are provided with reinforced bosses (7a, 7b) for retaining a piston pin, and wherein the target (8) is arranged on one of the reinforced bosses (7a, 7b).

7. Internal combustion engine according to one of claims 1 to 5, wherein the target (8) is arranged in the vicinity of the connecting rod small end.

8. Internal combustion engine according to one of the preceding claims, wherein the target (8) is a magnetic or metal body.
